# DEMANDE DE BREVET EUROPEEN

(11) **EP 0 942 529 A1**
(43) Date de publication de la demande: **15.09.1999**
(21) Numéro de dépôt: 99200636.1
(22) Date de dépôt: 04.03.1999
(51) Int. Cl.: H03H 7/48

(54) **Répartiteur de signaux à haute fréquence**

(30) Priorité: 13.03.1998 FR 9803141
(71) Demandeur: Koninklijke Philips Electronics N.V., 5621 BA Eindhoven (NL)
(72) Inventeur: Chanteau, Pierre, 75008 Paris (FR)
(74) Mandataire: Charpail, François

(57) **Abrégé**

Le répartiteur comporte un répartiteur à résistances (Ra, Rb, Rc) et, en plus, un transformateur symétriseur à deux enroulements qui est inséré dans le répartiteur à résistances entre la résistance d'entrée (Ra) et les résistances de sortie (Rb,Rc).

Applications : télédistribution large bande.

## Description

La présente invention concerne un répartiteur pour répartir des signaux dans une bande passante allant jusqu'à plusieurs gigahertz, muni d'une borne d'entrée et de deux bornes de sortie, comportant un transformateur symétriseur fait de deux enroulements symétriques comportant une branche d'entrée reliée à la borne d'entrée du répartiteur, et deux branches de sortie dont chacune est reliée à une borne de sortie du répartiteur.

Un répartiteur correspondant au préambule ci-dessus est connu de la demande de brevet DE-OS 24 57 522. Il s'agit d'un répartiteur à transformateur, dans des branches duquel a été ajouté un assemblage résistance/capacité en parallèle, de façon à augmenter l'isolation pour des fréquences au-dessous de 40 MHz, la fréquence de transition de l'assemblage résistance-capacité étant donc placée en limite basse de la bande passante de télévision, par conséquent sans effet dans cette bande placée, en télévison numérique, au-dessus de 70 MHZ.

Un objet de l'invention est d'augmenter la bande passante vers le haut tout en assurant une bonne isolation d'une sortie vis-à-vis de l'autre, et une bonne adaptation d'impédance en entrée et en sortie dans toute la bande passante.

A cet effet, la branche d'entrée du transformateur symétriseur est reliée à la borne d'entrée du répartiteur via une première impédance choisie de façon à être la moins réactive possible dans la bande passante, et chacune des branches de sortie du transformateur symétriseur est reliée à la borne de sortie correspondante du répartiteur via une autre impédance choisie de façon à être la moins réactive possible dans la bande passante.

L'invention est donc basée sur l'idée de combiner un dispositif à résistances et un dispositif à transformateur symétriseur, en les imbriquant en quelque sorte l'un dans l'autre.

Des modes particuliers de réalisation du répartiteur apparaissent dans les revendications dépendantes 2 à 5.

Ces aspects de l'invention ainsi que d'autres aspects plus détaillés apparaîtront plus clairement grâce à la description suivante d'un mode de réalisation constituant un exemple non limitatif.

La figure 1 illustre deux types de répartiteurs de l'art antérieur.

La figure 2 est un schéma d'un répartiteur selon l'invention.

La figure 3 illustre un mode de réalisation d'un transformateur.

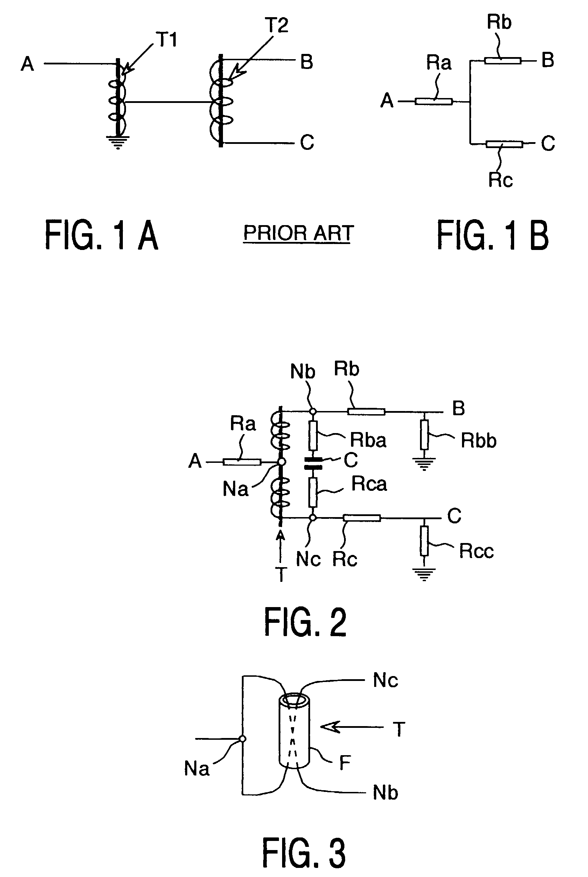

Un répartiteur de l'art antérieur est illustré par la figure 1A. Il comprend une borne d'entrée A et deux bornes de sortie B et C, et un premier transformateur T1 qui adapte l'impédance de ligne à l'entrée d'un second transformateur symétriseur T2. Il présente peu de pertes mais sa bande passante est limitée, essentiellement par les transformateurs.

Un autre répartiteur connu de l'art antérieur est illustré par la figure 1B. Il comprend, reliée à une entrée A, une résistance Ra dont le courant est divisé entre deux autres résistances Rb et Rc pour être réparti entre les deux sorties B et C. Il est meilleur marché et moins volumineux que celui de la figure 1A, et il permet une bande passante plus large, mais il présente plus de pertes et l'isolation d'une sortie B vis-à-vis de l'autre sortie C n'est que de 6 dB.

Le répartiteur de signaux à haute fréquence de la figure 2 est muni d'une borne d'entrée A et de deux bornes de sortie B et C. Il comporte un transformateur symétriseur T fait de deux enroulements symétriques reliés l'un à l'autre par une borne Na qui est reliée par une branche d'entrée à l'entrée A, chacune des autres bornes d'extrémité Nb ou Nc du transformateur symétriseur étant reliée par une branche de sortie à une des bornes de sortie B ou C. Le répartiteur comporte dans la branche d'entrée une impédance choisie de façon à être la moins réactive possible dans la bande passante, ici une résistance Ra, et dans chacune des branches de sortie une impédance la moins réactive possible dans la bande passante, ici une résistance, respectivement Rb et Rc. Une résistance sous la forme d'un composant discret, si elle est implantée avec soin, peut présenter très peu de capacité parasite, c'est-à-dire que son impédance est très peu réactive.

Une résistance Rbb est placée entre la sortie B et la masse, et une résistance Rcc est placée entre la sortie C et la masse.

Entre la sortie Nb du transformateur symétriseur et sa sortie Nc est placée une branche comportant une résistance Rba en série avec une capacité C et avec une seconde résistance Rca. En théorie les deux résistances Rba et Rca en série pourraient être résumées en une seule, néanmoins une réalisation symétrique est préférée.

Des valeurs donnant de bons résultats sont les suivantes : Ra=15Ω, Rb=Rc=30Ω, Rbb=Rcc=300Ω, Rba=Rca=300Ω, C=82pF.

La figure 3 montre un transformateur T, dans lequel les enroulements sont constitués chacun par un demi-tour de fil, reliant respectivement Na à Nb et Na à Nc (ces références désignent les mêmes objets que dans la figure 2), qui traversent un tube de ferrite F.

## Revendications

1. Répartiteur pour répartir des signaux dans une bande passante allant jusqu'à plusieurs gigahertz, muni d'une borne d'entrée et de deux bornes de sortie, comportant un transformateur symétriseur fait de deux enroulements symétriques comportant une branche d'entrée reliée à la borne d'entrée du répartiteur, et deux branches de sortie dont chacune est reliée à une borne de sortie du répartiteur, caractérisé en ce que la branche d'entrée du transformateur symétriseur est reliée à la borne d'entrée du répartiteur via une première impédance choisie de façon à être la moins réactive possible dans la bande passante, et chacune des branches de sortie du transformateur symétriseur est reliée à la borne de sortie correspondante du répartiteur via une autre impédance choisie de façon à être la moins réactive possible dans la bande passante.

2. Répartiteur de signaux selon la revendication 1, caractérisé en ce que les impédances choisies de façon à être les moins réactives possible dans la bande passante sont des résistances pures.

3. Répartiteur de signaux selon la revendication 1, caractérisé en ce qu'il comporte en outre une résistance entre chaque sortie et la masse.

4. Répartiteur de signaux selon la revendication 1, caractérisé en ce qu'il comporte en outre une branche reliant les sorties du transformateur symétriseur, dans laquelle est placée au moins une résistance en série avec une capacité.

5. Répartiteur de signaux selon la revendication 1, caractérisé en ce que les enroulements du transformateur sont constitués chacun par un demi-tour de fil qui traverse un tube de ferrite.
